**Europäisches Patentamt**

**European Patent Office**

**Office européen des brevets**

(19)

(11) Veröffentlichungsnummer: **0 064 716**
**B1**

(12) ## EUROPÄISCHE PATENTSCHRIFT

(45) Veröffentlichungstag der Patentschrift:
**26.08.87**

(21) Anmeldenummer: **82103779.3**

(22) Anmeldetag: **03.05.82**

(51) Int. Cl.⁴: **H 01 L 29/747**

(54) Triac und Verfahren zu seinem Betrieb.

(30) Priorität: **08.05.81 DE 3118291**

(43) Veröffentlichungstag der Anmeldung:
**17.11.82 Patentblatt 82/46**

(45) Bekanntmachung des Hinweises auf die Patenterteilung:
**26.08.87 Patentblatt 87/35**

(84) Benannte Vertragsstaaten:
**CH FR GB IT LI SE**

(56) Entgegenhaltungen:
**EP - A - 0 028 799**
**DE - A - 2 625 917**
**DE - A - 2 947 669**

(73) Patentinhaber: **Siemens Aktiengesellschaft Berlin und München, Wittelsbacherplatz 2, D-8000 München 2 (DE)**

(72) Erfinder: **Stoisiek, Michael, Dr. Dipl.-Phys., Robert-Koch-Strasse 24, D-8012 Ottobrunn (DE)**

## Beschreibung

Die Erfindung bezieht sich auf ein Triac nach der EP-A-0 028 799, die gemäss Artikel 54, Absatz 3 EPÜ, zu berücksichtigen ist.

Bei dem Triac nach der EP-A-0 028 799 mit dem üblichen, zwischen zwei Elektroden angeordneten Mehrschichten-Halbleiterkörper sind am n-Emitter des ersten Thyristors und am p-Emitter des zweiten Thyristors im Grenzgebiet zwischen beiden Thyristoren gategesteuerte MIS-Strukturen vorgesehen, die steuerbare Emitter-Kurzschlusspfade enthalten, wobei die steuerbaren Kurzschlusspfade jeweils ein erstes Halbleitergebiet eines ersten Leitungstyps, das mit der den zugehörigen Emitter kontaktierenden Elektrode verbunden ist, ein zweites Halbleitergebiet des ersten Leitungstyps, das mit der an den zugehörigen Emitter angrenzenden Basisschicht verbunden ist, und einen zwischen diesen Gebieten liegenden Halbleiterbereich eines zweiten Leitungstyps, der von einer gegenüber dem Halbleiterkörper elektrisch isolierten Gate-Elektrode überdeckt ist, aufweisen.

Die MIS-Strukturen werden hierbei so angesteuert, dass die Emitter-Kurzschlusspfade jedes Thyristors im blockierten Zustand desselben bzw. vor seiner Zündung als Stabilisierungskurzschlüsse wirken. Dabei verhindern sie unbeabsichtigte Zündvorgänge, die beispielsweise beim Ansteigen von Blockierspannungen auf höhere Werte oder bei einem schnellen Anstieg dieser Blockierspannungen auftreten können. Während jedes Zündvorganges sind die Emitter-Kurzschlusspfade des von diesem Vorgang jeweils betroffenen Thyristors abgeschaltet, um seine Zündempfindlichkeit wesentlich zu erhöhen. Da die Emitter-Kurzschlusspfade bei den Nulldurchgängen einer dem Triac zugeführten Wechselspannung jeweils wirksam geschaltet sind, kann das Triac auch bei hohen Kommutierungs-dU/dt-Werten, d.h. bei grossen Änderungsgeschwindigkeiten der Wechselspannung im Bereich ihrer Nulldurchgänge, betrieben werden.

Der vorliegenden Erfindung liegt die Aufgabe zugrunde, eine einfache und leicht herzustellende Ausführungsform eines Triac der eingangs genannten Art anzugeben. Das wird durch eine Ausbildung desselben nach dem Patentanspruch 1 erreicht.

Der hiermit erzielbare Vorteil besteht insbesondere darin, dass die Herstellung der für die steuerbaren Emitter-Kurzschlusspfade erforderlichen Halbleitergebiete im Rahmen derjenigen Dotierungsschritte erfolgt, die bereits zur Herstellung der einzelnen Halbleitergebiete bzw. -schichten des Triac benötigt werden, so dass der Mehraufwand für die steuerbaren Emitter-Kurzschlusspfade sehr klein gehalten werden kann.

Aus der US-A-3 243 669, vgl. insbesondere Fig. 9, und der DE-A-2 625 917 sind Thyristoren mit steuerbaren Emitter-Kurzschlusspfaden in Form von MIS-Strukturen bekannt, die zum Zwecke eines schnellen Löschens der Thyristoren wirksam geschaltet werden. Nach der DE-A-2 625 917 dienen die steuerbaren Emitter-Kurzschlüsse auch dazu, dass sie beim Anlegen eines geeigneten äusseren Signals an die Gate-Elektroden der MIS-Strukturen die Zündung der Thyristoren durch einen einer Basisschicht zugeführten Zündstrom verhindern.

Aus der DE-A-2 625 917 ist auch ein Triac bekannt, das mit steuerbaren Emitter-Kurzschlusspfaden ausgestattet ist, die beim Auftreten von Blockierspannungen an einem der beiden Thyristoren des Triac jeweils für diesen wirksam geschaltet werden, um seine Zündung zu verhindern, was zur Folge hat, dass der Zündvorgang unter Anwendung einer die Zündleistung liefernden Lichtquelle lediglich während eines Nulldurchgangs der dem Triac zugeführten Wechselspannung erfolgt. Zu den hieraus bekannten, steuerbaren Emitter-Kurzschlusspfaden gehören jeweils ein erstes Halbleitergebiet eines ersten Leitungstyps, das aus einem Randbereich des n(p)-Emitters eines Thyristors besteht, ferner ein zweites Halbleitergebiet desselben Leitungstyps, das im Abstand vom n(p)-Emitter in die an diesen angrenzende Basisschicht eingefügt ist, und der zwischen diesen Halbleitergebieten liegende, einen zweiten Leitungstyp aufweisende Teilbereich der Basisschicht, der von einem isolierten Gate überdeckt ist. Ein Triac mit steuerbaren Emitter-Kurzschlusspfaden, die vor dem Zünden jedes der beiden Thyristoren des Triac jeweils wirksam geschaltet sind, um diesen zu stabilisieren, während sie bei der im Verlauf einer Halbwelle der dem Triac zugeführten Wechselspannung erfolgenden Zündung jedes der beiden Thyristoren, soweit sie diesem zugeordnet sind, jeweils abgeschaltet sind, lässt sich hieraus jedoch nicht entnehmen.

Aus der DE-A-2 947 669 (Fig. 4) ist ein Triac bekannt, bei dem der n-Emitter des einen Thyristors im Grenzgebiet zwischen beiden Thyristoren mit steuerbaren Emitter-Kurzschlüssen zur Verbesserung des dV/dt-Verhaltens versehen ist. Ein solcher Emitter-Kurzschluss besteht aus einem Randbereich des n-Emitters, aus einem in die angrenzende p-Basisschicht eingefügten n-leitenden Kurzschlussgebiet, das über eine leitende Belegung mit der p-Basis verbunden ist, und aus einem von einer Gate-Elektrode überdeckten Halbleiterbereich, der durch einen Teilbereich der p-Basisschicht gebildet wird. Der p-Emitter des anderen Thyristors weist aber im Unterschied zur vorliegenden Erfindung keine steuerbaren Emitter-Kurzschlüsse auf. Ausserdem unterscheidet sich dieser Triac von der Erfindung durch einen planaren Aufbau, bei dem die p-Basisschichten beider Thyristoren im Abstand nebeneinander in einen n-leitenden Halbleiterkörper eingefügt sind, der die n-Basisschichten beider Thyristoren bildet.

Die Ansprüche 2 bis 6 betreffen Weiterbildungen des Triacs nach der Erfindung, während die Ansprüche 7 und 8 auf Verfahren zum Betrieb eines erfindungsgemässen Triacs gerichtet sind.

Nachfolgend wird die Erfindung anhand der Zeichnung näher erläutert. Dabei zeigen:

Fig. 1 ein erstes Ausführungsbeispiel der Erfindung,

Fig. 2 Spannungs-Zeit-Diagramme zur Erläuterung von Fig. 1,

Fig. 3 eine erste Teilschaltung von Fig. 1,

Fig. 4 eine zweite Teilschaltung von Fig. 1 und

Fig. 5 eine dritte Teilschaltung von Fig. 1.

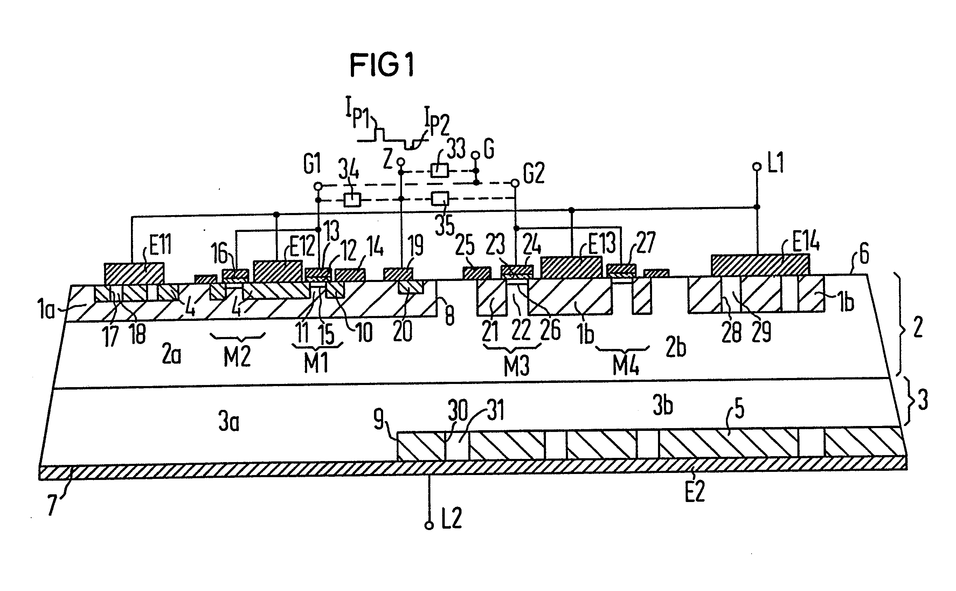

In Fig. 1 ist ein Triac mit einem Körper aus dotiertem Halbleitermaterial, z.B. Silizium, dargestellt, der mehrere aufeinanderfolgende Schichten abwechselnder Leitungstypen aufweist. Eine erste p-leitende Schicht bildet sowohl die p-Basisschicht 1a eines die linke Hälfte von Fig. 1 einnehmenden ersten Thyristors als auch einen zweiteiligen p-Emitter 1b eines zweiten, in der rechten Hälfte von Fig. 1 dargestellten Thyristors. Eine an 1a und 1b angrenzende, n-leitende Schicht 2 bildet die n-Basisschichten 2a und 2b bei den Thyristoren, während eine unterhalb von 2 angeordnete p-leitende Schicht 3 den p-Emitter 3a des linken und die p-Basisschicht 3b des rechten Thyristors umfasst. In die Basisschicht 1a ist ein zweiteiliger n-Emitter 4 des ersten Thyristors eingefügt, während in die Basisschicht 3b der n-Emitter 5 des zweiten Thyristors eingefügt ist. Die beiden Teile des n-Emitters 4 sind mit Teilen E11 und E12 einer ersten Elektrode aus elektrisch leitendem Material, z.B. Aluminium, verbunden, die an einen gemeinsamen Anschluss L1 geführt sind. Die beiden Teile 1b des p-Emitters des rechten Thyristors sind mit weiteren Teilen E13 und E14 der ersten Elektrode verbunden, die ebenfalls an L1 angeschlossen sind. Der p-Emitter 3a und der n-Emitter 5 sind in der Grenzfläche 7 des Halbleiterkörpers mit einer zweiten Elektrode E2 aus elektrisch leitendem Material, z.B. Aluminium, belegt, die einen Anschluss L2 aufweist.

Der Halbleiterkörper des Triac nach Fig. 1 weist die Form einer flachen, z.B. runden Scheibe auf, während die p-Basisschicht 1a des linken und der n-Emitter 5 des rechten Thyristors jeweils etwa die halbe Querschnittsfläche des Halbleiterkörpers einnehmen. Ihre vertikalen Begrenzungsflächen 8 und 9 verlaufen dabei im wesentlichen senkrecht zur Bildebene von Fig. 1. Die Teile 4 des n-Emitters des linken Thyristors und die Teile 1b des p-Emitters des rechten Thyristors stellen jeweils streifenförmige, langgestreckte Halbleitergebiete dar, die im wesentlichen senkrecht zur Bildebene von Fig. 1 über die ganze Grenzfläche 6 des Halbleiterkörpers verlaufen.

Am rechten Rand des rechten n-Emitterteils 4 ist ein n-leitendes Kurzschlussgebiet 10 in die p-Basisschicht 1a eingefügt, das sich bis zur Grenzfläche 6 erstreckt. Das Kurzschlussgebiet 10 weist einen Abstand von dem n-Emitterteil 4 auf, der durch die Breite eines Teilbereiches 11 der p-Basisschicht 1a bestimmt ist. Dieser Teilbereich 11 wird von einer auf der Grenzfläche 6 aufgebrachten, dünnen, elektrisch isolierenden Schicht 12 überdeckt, auf der ein Gate 13 aus elektrisch leitendem Material, z.B. hochdotiertem polykristallinen Silizium, oder aus Metall, z.B. Aluminium, aufgebracht ist. Das Gate 13 ist mit einem Steueranschluss G1 verbunden. Der rechte Rand des Kurzschlussgebietes 10 wird von einer leitenden Belegung 14 kontaktiert, die den dort befindlichen pn-Übergang zwischen den Teilen 10 und 1a niederohmig überbrückt.

Die rechte Randzone des rechten n-Emitterteils 4 bildet ein erstes n-leitendes Halbleitergebiet einer MIS-Struktur M1, zu der weiterhin das Kurzschlussgebiet 10 als zweites n-leitendes Halbleitergebiet und der Teilbereich 11 als p-leitendes Halbleitergebiet sowie die Teile 12 und 13 gehören. Handelt es sich bei M1 um eine Struktur des Verarmungstyps, so ist bei spannungslosem Gate 13 ein die Teile 4 und 10 niederohmig miteinander verbindender n-leitender Kanal 15 vorhanden. Der Kanal 15 kann z.B. aus einer Inversionsschicht bestehen, die durch ein an der Grenzfläche 6 oberhalb des Bereiches 11 herrschendes elektrisches Feld aufgebaut worden ist, oder durch eine unmittelbar an der Grenzfläche 6 in den Bereich 11 eingefügte, zusätzliche n-Dotierung gebildet sein. Die Teile 15 und 10 bilden in Verbindung mit der leitenden Belegung 14 einen Emitter-Kurzschlusspfad, der die Teile 4 und 1a niederohmig miteinander verbindet. Führt man dem Anschluss G1 eine negative Steuerspannung zu, so wird der Kanal 15 aufgehoben bzw. hochohmig geschaltet, so dass der genannte Emitter-Kurzschlusspfad abgeschaltet ist.

Am linken Rand des rechten n-Emitterteils 4 ist eine in analoger Weise ausgebildete weitere MIS-Struktur M2 vorgesehen, deren Gate 16 ebenfalls mit G1 verbunden ist. Der linke n-Emitterteil 4 weist Ausnehmungen 17 auf, die von Ansätzen 18 der p-Basisschicht 1a durchdrungen werden, wobei diese Ansätze in der Grenzfläche 6 von dem Teil E11 der ersten Elektrode kontaktiert werden. Die Ansätze 18 bilden sog. feste Emitterkurzschlüsse.

Auf der p-Basisschicht 1a ist eine Zündelektrode 19 vorgesehen, die mit einem Anschluss Z eines Zündstromkreises verbunden ist. Die Elektrode 19 kontaktiert sowohl das Gebiet 1a als auch ein n-leitendes Steuergebiet 20, das innerhalb der Schicht 1a angeordnet ist und sich bis zur Grenzfläche 6 erstreckt.

Am linken Rand des linken p-Emitterteils 1b ist ein p-leitendes Kurzschlussgebiet 21 in die n-Basisschicht 2b so eingefügt, dass es sich bis zur Grenzfläche 6 erstreckt. Der Abstand des Kurzschlussgebietes 21 von dem linken p-Emitterteil 1b ist durch die Breite eines Teilbereiches 22 der n-Basisschicht 2b bestimmt, der von einer auf der Grenzfläche 6 aufgebrachten, dünnen, elektrisch isolierenden Schicht 23 überdeckt ist. Auf dieser ist ein Gate 24 aus elektrisch leitendem Material, z.B. hochdotiertem polykristallinen Silizium oder aus Metall, z.B. Aluminium, aufgebracht, das mit einem Steueranschluss G2 verbunden ist. Der linke Rand des Kurzschlussgebietes 21 wird von einer leitenden Belegung 25 kontaktiert, die soweit verlängert ist, dass sie einen Teil der n-Basisschicht 2b kontaktiert, so dass der an dieser Stelle befindliche pn-Übergang zwischen den Teilen 21 und 2b niederohmig überbrückt wird. Die Teile 1b und 21 bis 24 stellen eine MIS-Struktur M3 dar.

Gehört sie dem Verarmungstyp an, so weist sie bei spannungslosem Gate 24 einen p-leitenden Kanal 26 zwischen den Teilen 1b und 21 an der Grenzfläche 6 auf. Entsprechend dem n-Kanal 15 kann auch der p-Kanal 26 aus einer Inversionsschicht gebildet sein, die durch ein an der Grenzfläche 6 vorhandenes elektrisches Feld hervorgerufen wird, oder aus einer flachen p-Dotierung bestehen, die im Bereich 22 unmittelbar an der Grenzfläche 6 eingebracht worden ist. Die Teile 26 und 21 bilden in Verbindung mit der leitenden Belegung 25 eine Emitter-Kurzschlusspfad, der die Teile 1b und 2b niederohmig miteinander verbindet. Wird dem Steueranschluss G2 eine positive Steuerspannung zugeführt, so wird der Kanal 26 unterbrochen bzw. hochohmig geschaltet und somit der zuletzt genannte Emitter-Kurzschlusspfad abgeschaltet.

Am rechten Rand des linken p-Emitterteils 1b ist eine in analoger Weise aufgebaute MIS-Struktur M4 vorgesehen, deren Gate 27 mit dem Steueranschluss G2 verbunden ist.

Der rechte p-Emitterteil 1b weist Ausnehmungen 28 auf, die von Ansätzen 29 der n-Basisschicht 2b durchdrungen werden. Die Ansätze 29 werden in der Grenzfläche 6 von dem Teil E14 der ersten Elektrode kontaktiert und bilden somit fest Emitterkurzschlüsse. Der n-Emitter 5 weist Ausnehmungen 30 auf, die von Ansätzen 31 der p-Basisschicht 3b durchdrungen werden, welche mit der Elektrode E2 verbunden sind, so dass auch der n-Emitter 5 mit festen Emitterkurzschlüssen versehen ist.

Im Betrieb liegt eine Wechselspannung an den Anschlüssen L1 und L2, die mit einem äusseren Laststromkreis verbunden sind. Betrachtet man eine erste Halbwelle dieser Wechselspannung, die den Anschluss L2 auf ein positiveres Potential legt als L1, so befindet sich der in der linken Hälfte von Fig. 1 dargestellte Thyristor im blockierten Zustand, in dem er trotz der in seiner Durchlassrichtung anliegenden Spannungshalbwelle keinen Laststrom zwischen L1 und L2 zulässt. Die in der Raumladungszone am pn-Übergang zwischen den Basisschichten 1a und 2a thermisch generierten Defektelektronen werden über die bei spannungslosem Steueranschluss G1 wirksamen Kurzschlusspfade, z.B. 15, 10, 14, der Strukturen M1 und M2 und durch die festen Emitterkurzschlüsse 17, 18 zu den Teilen E11 und E12 der ersten Elektrode abgeleitet, so dass aus den n-Emitterteilen 4 keine Ladungsträger in die Basisschicht 1a injiziert werden.

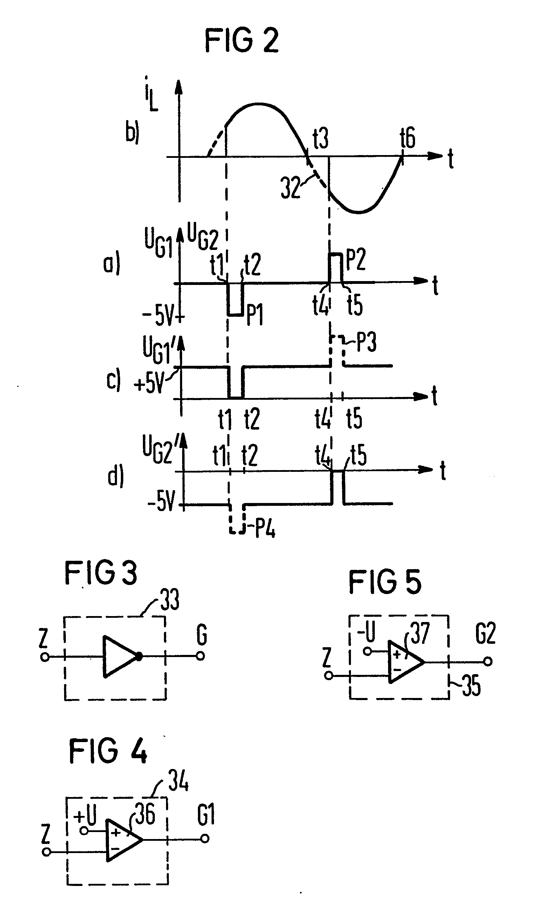

Um den in Fig. 1 linksseitig dargestellten Thyristor zu zünden, wird dem Anschluss Z zum Zeitpunkt t1 eine positiver Zündstromimpuls $I_{P1}$ zugeführt. Gleichzeitig wird der Anschluss G1 mit einem negativen Impuls P1 von z.B. – 5 Volt beaufschlagt, durch den die Kurzschlusspfade der Strukturen M1 und M2 abgeschaltet werden. In Fig. 2a ist über der Zeit t die dem Anschluss G1 zugeführte Steuerspannung $U_{G1}$ aufgetragen. Sie besteht aus dem Spannungsimpuls P1, der im Zeitintervall t1 bis t2 zugeführt wird. Durch die Abschaltung der Emitter-Kurzschlusspfade wird die Zündempfindlichkeit des betrachteten Thyristors soweit erhöht, dass er schnell und grossflächig zündet. Damit beginnt beim Auftreten der Impulse $I_{P1}$ und P1 ein Laststrom $i_L$ zwischen den Anschlüssen L1 und L2 zu fliessen, dessen Zeitabhängigkeit unter der Voraussetzung einer sinusförmigen Wechselspannung an L1 und L2 und eines ohmschen Widerstandes im Laststromkreis in Fig. 2b dargestellt ist.

Der in Fig. 1 rechtsseitig dargestellte Thyristor ist bis zum Zeitpunkt t3, d.h. bis zum Nulldurchgang der Wechselspannung an L1, L2, in Sperrrichtung gepolt, so dass er nicht gezündet ist und über ihn keine Laststromanteile fliessen.

Da die über die Strukturen M3 und M4 verlaufenden Emitter-Kurzschlusspfade bei spannungslosem Steueranschluss G2 wirksam geschaltet sind, können Defektelektronen, die aus dem Bereich des gezündeten linken Thyrisotrs in den Grenzbereich zwischen beiden Thyristoren gelangt sind, über den Teil E13 der ersten Elektrode abgeleitet werden. Dies gilt auch zunächst für den Zeitraum nach t3, in dem der linke Thyristor gesperrt ist und der rechte Thyristor in Durchlassrichtung gepolt ist. Erst beim Auftreten eines negativen Zündstromimpulses $I_{P2}$ am Anschluss Z zum Zeitpunkt t4 und eines mit diesem zeitlich zusammenfallenden positiven Spannungsimpulses P2 am Steueranschluss G2 zündet der rechte Thyristor von Fig. 1, wobei während des ihn betreffenden Zündvorgangs die Emitter-Kurzschlusspfade der Strukturen M3 und M4 vorübergehend abgeschaltet sind. In Fig. 2a ist auch die dem Anschluss G2 zugeführte Steuerspannung $U_{G2}$ über der Zeit t aufgetragen. Diese besteht aus dem positiven Spannungsimpuls P2, der lediglich während des Zündvorganges für den rechten Thyristor, d.h. im Zeitintervall t4 bis t5, an G2 anliegt. Bis zum nächstfolgenden Nulldurchgang der an L1 und L2 anliegenden Wechselspannung zum Zeitpunkt t6 führt dann der rechte Thyristor in Fig. 1 den Laststrom $i_L$.

Ohne die beschriebene Wirkung der in den Strukturen M3 und M4 enthaltenen Emitter-Kurzschlusspfade würde es zu einer unerwünschten Zündung des rechten Thyristors vor dem Zeitpunkt t4 kommen, da vom linken Thyristor stammende, aus der Schicht 2a in die Schicht 2b gelangte Ladungsträger eine vorschnelle Zündung veranlassen würden. In diesem Fall würde der Laststrom $i_L$ im Zeitraum von t3 bis t4 nicht wie gewünscht auf Null absinken, sondern dem Kurventeil 32 entsprechen, der in Fig. 2 gestrichelt eingezeichnet ist. Damit wäre aber ein normaler Betrieb eines Triac nicht möglich. Die festen Emitterkurzschlüsse 28, 29 und 30, 31 vergrössern die Stabilität des rechten Thyristors von Fig. 1, so dass ein unerwünschtes Zünden desselben im Zeitintervall von t3 bis t4 sicher vermieden wird. Die festen Emitterkurzschlüsse 17, 18 erhöhen die Stabilität des linken Thyristors von Fig. 1 vor dem Zeitpunkt t1.

Nach einer Weiterbildung der Erfindung können die Anschlüsse G1 und G2 mit einem gemeinsamen Anschluss G verbunden werden. Diesem wird dann eine Spannung zugeführt, die dem Spannungs-Zeit-Diagramm von Fig. 2a entspricht und aus den Impulsen P1 und P2 besteht.

Nach einer weiteren Ausgestaltung der Erfindung kann die dem Anschluss G zuzuführende Spannung auch aus der am Anschluss Z abgreifbaren Spannung abgeleitet werden, die bei Einspeisung der Zündstromimpulse $I_{P1}$ und $I_{P2}$ auftritt. Hierzu dient eine Polaritätsumkehrschaltung 33, die gemäss Fig. 3 aus einem invertierenden Verstärker besteht, dessen Eingang mit Z und dessen Ausgang mit G beschaltet ist.

Nach einer anderen Ausgestaltung der Erfindung können die MIS-Strukturen M1 bis M4 auch als solche des Anreicherungstyps ausgebildet sein. Hierbei ist es erforderlich, dem Steueranschluss G1 zur Wirksamschaltung der über M1 und M2 verlaufenden Emitter-Kurzschlusspfade eine in Fig. 2c über der Zeit t dargestellte Steuerspannung $U_{G1}'$ zuzuführen, die beispielsweise + 5 Volt beträgt und lediglich während des Zeitintervalls t1 bis t2 zur Abschaltung dieser Kurzschlusspfade kurzzeitig unterbrochen wird, während dem Steueranschluss G2 die in Fig. 2d dargestellte Steuerspannung $U_{G2}'$ zuzuführen ist, die z.B. −5 Volt beträgt und lediglich während des Zeitintervalls t4 bis t5 abgeschaltet wird. Damit ergibt sich für die Strukturen M1 bis M4 die bereits beschriebene Wirkungsweise.

Die Steuerspannung $U_{G1}'$ kann über eine Zusatzschaltung 34 abgeleitet werden, die zwischen die Anschlüsse Z und G1 geschaltet ist. Die Ableitung der Steuerspannung $U_{G2}'$ kann in ähnlicher Weise über eine Zusatzschaltung 35 erfolgen, die zwischen die Anschlüsse Z und G2 geschaltet ist. Die Zusatzschaltung 34 ist mit Vorteil entsprechend Fig. 4 ausgebildet und besteht aus einem Differenzverstärker 36, dessen positiver Eingang mit einer der Amplitude von P1 entsprechenden Spannung +U beschaltet ist, während ein negativer Eingang mit dem Anschluss Z verbunden ist und der Ausgang an G1 liegt. Die Zusatzschaltung 35 besteht zweckmässigerweise aus einem Differenzverstärker 37 gemäss Fig. 5, dessen positiver Eingang mit einer der Amplitude von P2 entsprechenden Spannung −U beschaltet ist, während sein negativer Eingang am Anschluss Z liegt und sein Ausgang mit G2 verbunden ist. Bei der Ableitung der Spannung $U_{G1}'$ über die Zusatzschaltung 34 tritt im Zeitraum von t4 bis t5 ein positiver Impuls P3 auf, der sich dem Spannungswert von z.B. +5 Volt überlagert. Ebenso tritt im Zeitintervall t1 bis t2 ein negativer Impuls P4 auf, der sich der über 35 abgeleiteten Spannung $U_{G2}'$ überlagert. Die Impulse P4 und P5 beeinträchtigen die Funktion der Schaltung nicht.

Die Länge der n-Kanäle, z.B. 15, von M1 und M2 und die der p-Kanäle, z.B. 26, von M3 und M4 kann etwa 2 bis 10 µm betragen, während der Durchmesser des Triacs nach Fig. 1 z.B. 1 cm und der Abstand der einander gegenüberliegenden Grenzflächen zweckmässigerweise etwa 200 bis 600 µm beträgt.

Mit Vorteil kann die Belegung 14 mit der Elektrode 19 zu einer gemeinsamen Belegung zusammengefasst sein, die mit Z verbunden ist.

**Patentansprüche**

1. Triac mit einem zwischen zwei Elektroden (E11, E12, E13, E14; E2) angeordneten Mehrschichten-Halbleiterkörper, bei dem eine erste Schicht die p-Basissicht (1a) eines ersten und den p-Emitter (1b) eines zweiten Thyristors bildet, eine zweite Schicht (2) die n-Basisschichten (2a, 2b) beider Thyristoren darstellt und eine dritte Schicht (3) den p-Emitter (3a) des ersten und die p-Basisschicht (3b) des zweiten Thyristors bildet, bei dem der n-Emitter (4) des ersten Thyristors in die erste Schicht und der n-Emitter (5) des zweiten Thyristors in die dritte Schicht (3) eingefügt und mit den betreffenden Elektroden (E11, E12, E13, E14; E2) verbunden sind, bei dem am n-Emitter (4) des ersten und am p-Emitter (1b) des zweiten Thyristors im Grenzbereich zwischen beiden Thyristoren gategesteuerte MIS-Strukturen (M1, M3) vorgesehen sind, die steuerbare Emitter-Kurzschlusspfade enthalten und bei dem die steuerbaren Emitter-Kurzschlusspfade jeweils ein erstes Halbleitergebiet eines ersten Leitungstyps, das mit der den zugehörigen Emitter (4, 1b) kontaktierenden Elektrode (E12, E13) verbunden ist, ein zweites Halbleitergebiet (10, 21) des ersten Leitungstyps, das mit der an den zugehörigen Emitter angrenzenden Basisschicht (1a, 2b) verbunden ist und einen zwischen diesen Gebieten liegenden Halbleiterbereich (11, 22) eines zweiten Leitungstyps, der von einer gegenüber dem Halbleiterkörper elektrisch isolierten Gate-Elektrode (13, 24) überdeckt ist, und bei dem das erste Halbleitergebiet aus einem Randbereich des n(p)-Emitters (4, 1b) besteht, das zweite Halbleitergebiet aus einem in die angrenzende p(n)-Basisschicht (1a, 2b) eingefügten n(p)-leitenden Kurzschlussgebiet (10, 21) gebildet ist, das über eine leitende Belegung (14, 25) mit der p(n)-Basisschicht (1a, 2b) verbunden ist, und der von der Gate-Elektrode (13, 24) überdeckte Halbleiterbereich aus einem Teilbereich (11, 22) der p(n)-Basisschicht (1a, 2b) besteht.

2. Triac nach Anspruch 1, bei dem wenigstens eine MIS-Struktur (M1) dem Verarmungstyp angehört und ein in ihren überdeckten Halbleiterbereich (11) eingefügtes Kanalgebiet (15) des ersten Leitungstyps aufweist.

3. Triac nach Anspruch 1 oder 2, bei dem der n-Emitter (4) des ersten und der p-Emitter (1b) des zweiten Thyristors in mehrere streifenförmige Teilgebiete aufgeteilt sind, die jeweils von Teilen (E11, E12, E13, E14) der die Emitter (4, 1b) kontaktierenden Elektrode kontaktiert werden und bei dem eine Mehrzahl von steuerbaren Emitter-Kurzschlusspfaden randseitig zu den streifenförmigen Teilgebieten angeordnet sind.

4. Triac nach einem der Ansprüche 1 bis 3, bei dem die gesteuerten Emitter-Kurzschlusspfade jedes einzelnen Thyristors einen ihnen zugeordneten Steueranschluss (G1, G2) aufweisen oder bei dem die gesteuerten Emitter-Kurzschlusspfade beider Thyristoren einen gemeinsamen Steueranschluss (G) aufweisen.

5. Triac nach Anspruch 4, bei dem die p-Basisschicht (1a) des einen Thyristors mit einer Zündelektrode (19) versehen ist, die einen Anschluss (Z) für einen Zündstromkreis aufweist und ein in diese Basisschicht (1a) eingefügtes, zu dieser entgegengesetzt dotiertes Steuergebiet (20) kontaktiert, und bei dem der Anschluss (Z) des Zündstromkreises über eine Zusatzschaltung (33) mit dem gemeinsamen Steueranschluss (G) verbunden ist oder über weitere Zusatzschaltungen (34, 35) mit den den gesteuerten Emitter-Kurzschlusspfaden der einzelnen Thyristoren zugeordneten Steueranschlüssen (G1, G2) verbunden ist.

6. Triac nach Anspruch 5, bei dem die Zusatzschaltung (33) aus einem invertierenden Verstärker besteht und die weiteren Zusatzschaltungen (34, 35) bei Verwendung von MIS-Strukturen vom Anreicherungstyp als Polaritätsumkehrschaltungen mit pegelverschiebender Funktion ausgebildet sind.

7. Verfahren zum Betrieb eines Triacs nach Anspruch 4 oder 5, bei dem dem Steueranschluss (G1) der Emitter-Kurzschlusspfade des ersten Thyristors Spannungsimpulse (P1) einer ersten Polarität und dem Steueranschluss (G2) der Emitter-Kurzschlusspfade des zweiten Thyristors Spannungsimpulse einer zweiten Polarität (P2) zugeführt werden.

8. Verfahren zum Betrieb eines Triacs nach Anspruch 4 oder 5, bei dem dem gemeinsamen Steueranschluss (G) Spannungsimpulse (P1, P2) beider Polaritäten zugeführt werden.

**Claims**

1. A triac having a multi-layer semiconductor body arranged between two electrodes (E11, E12, E13, E14; E2), wherein a first layer forms the p-base layer (1a) of a first thyristor and the p-emitter (1b) of a second thyristor, a second layer (2) forms the n-base layers (2a, 2b) of the two thyristors, and a third layer (3) forms the p-emitter (3a) of the first thyristor and the p-base layer (3b) of the second thyristor, wherein the n-emitter (4) of the first thyristor is inset in the first layer and the n-emitter (5) of the second thyristor is inset in the third layer (3) and are connected to the respective electrodes (E11, E12, E13, E14; E2), wherein gate-controlled MIS-structure (M1, M3) which contain controllable emitter short-circuit paths are arranged at the n-emitter (4) of the first thyristor and the p-emitter (1b) of the second thyristor in the boundary zone between the two thyristors, wherein the controllable emitter short-circuit paths each comprise a first semiconductor zone of a first conductivity type which is connected to the electrode (E12, E13) which contacts the associated emitter (4, 1b), a second semiconductor zone (10, 21) of the first conductivity type which is connected to the base layer (1a, 2b) which adjoins the associated emitter, and a semiconductor region (11, 22) of a second conductivity type which is arranged between these zones and which is covered by a gate electrode (13, 24) which is electrically insulated with respect to the semiconductor body, and wherein the first semiconductor zone consists of an edge zone of the n(p)-emitter (4, 1b), the second semiconductor zone consists of a n(p)-conducting short-circuit zone (10, 21) which is inset in the adjacent p(n)-base layer (1a, 2b) and is connected through a conductive coating (14, 25) to the p(n)-base layer (1a, 2b), and the semiconductor region which is covered by the gate electrode (13, 24) consists of a subsidiary region (11, 22) of the p(n)-base layer (1a, 2b).

2. A triac as claimed in Claim 1, wherein at least one MIS-structure (M1) is of the depletion type and comprises a channel zone (15) of the first conductivity type arranged in its covered semiconductor region (11).

3. A triac as claimed in Claim 1 or 2, wherein the n-emitter (4) of the first thyristor and the p-emitter (1b) of the second thyristor are divided into a plurality of strip-shaped part-zones, each of which is contacted by parts (E11, E12, E13, E14) of the electrode which contacts the emitters (4, 1b), and wherein a plurality of controllable emitter short-circuit paths are arranged at the edges of the strip-shaped part-zones.

4. A triac as claimed in one of the Claims 1 to 3, wherein the controlled emitter short-circuit paths of each individual thyristor have a control terminal (G1, G2) assigned to them, or wherein the controlled emitter short-circuit path of both thyristors have a common control terminal (G).

5. A triac as claimed in Claim 4, wherein the p-base layer (1a) of the first thyristor is provided with an ignition electrode (19) which has a terminal (Z) for an ignition circuit and contacts a control zone (20) which is arranged in this base layer (1a) and is doped oppositely thereto, and wherein the terminal (Z) of the ignition circuit is connected by way of an additional circuit (33) to the common control terminal (G), or is connected by way of further additional circuits (34, 35) to the control terminals (G1, G2) which are assigned to the controlled emitter short-circuit paths of the individual thyristors.

6. A triac as claimed in Claim 5, wherein the additional circuit (33) consists of an inverting amplifier and, when MIS-structures of the enhancement type are used, the further additional circuits (34, 35) consist of polarity reversal circuits with a level shifting function.

7. A method for operating a triac as claimed in Claim 4 or 5, wherein the control terminal (G1) of the emitter short-circuit paths of the first thyristor is supplied with voltage pulses (P1) of a first polarity and the control terminal (G2) of the emitter short-circuit paths of the second thyristor is supplied with voltage pulses of a second polarity (P2).

8. A method for the operation of a triac as claimed in Claim 4 or 5, wherein the common control terminal (G) is supplied with voltage pulses (P1, P2) of both polarities.

## Revendications

1. Triac comportant un corps semiconducteur à couches multiples, qui est disposé entre deux électrodes (E11, E12, E13, E14; E2) et dans lequel une première couche forme la couche de base (1a) de type p d'un premier thyristor et l'émetteur (1b) de type p d'un second thyristor, une seconde couche (2) représente les couches de base (2a, 2b) de type n des deux thyristors, et une troisième couche (3) forme l'émetteur (3a) de type p du premier thyristor et la couche de base (3b) de type p du second thyristor, et dans lequel l'émetteur (4) de type n du premier thyristor et l'émetteur (5) de type n du second thyristor sont insérés respectivement dans la première couche et dans la troisième couche (3) et sont reliés aux électrodes concernées (E11, E12, E13, E14; E2), et dans lequel il est prévu au niveau de l'émetteur (4) de type n du premier thyristor et au niveau de l'émetteur (1b) de type p du second thyristor, dans la zone frontière entre ces deux thyristors, des structures MIS (M1, M3) commandées par la grille, qui contiennent des voies de court-circuit d'émetteur commandables, et dans lequel les voies de court-circuit d'émetteur commandables comportent respectivement une première région semiconductrice, qui possède un premier type de conductivité et est reliée à l'électrode (E12, E13) qui est en contact avec l'émetteur associé (4, 1b) une seconde région semiconductrice (10, 21) qui possède le premier type de conductivité et est reliée à la couche de base (1a, 2b) jouxtant l'émetteur associé, et une région semiconductrice (11, 22), qui possède un second type de conductivité, est située entre ces deux régions et est recouverte par une électrode (13, 24) isolée du point de vue électrique par rapport au corps semiconducteur, et dans lequel la première région semiconductrice est constituée par une zone marginale de l'émetteur (4, 1b) de type n (p) la seconde région semiconductrice est constituée par une région de court-circuit (10, 21) conductrice du type n (p) et insérée dans la couche de base contiguë (1a, 2b) de type (n), et qui est reliée par l'intermédiaire d'un revêtement conducteur (14, 25), à la couche de base (1a, 2b) de type p (n), et la zone semiconductrice recouverte par l'électrode de grille (13, 24) est constituée par une zone partielle (11, 22) de la couche de base (1a, 2b) de type p (n).

2. Triac suivant la revendication 1, dans lequel au moins une structure MIS (M) est du type à appauvrissement et comporte une région de canal (15) possédant le premier type de conductivité et insérée dans la zone semiconductrice recouverte (11) de cette structure.

3. Triac suivant la revendication 1 ou 2, dans lequel l'émetteur (4) de type n du premier thyristor et l'émetteur (1b) de type p du second thyristor sont subdivisés en plusieurs régions partielles en forme de bandes qui sont respectivement en contact avec des parties (E11, E12, E13, E14) de l'électrode qui est en contact avec les émetteurs (4, 1b), et dans lequel une multiplicité de voies de court-circuits d'émetteur commandables sont disposées sur le bord des régions partielles en forme de bandes.

4. Triac suivant l'une des revendications 1 à 3, dans lequel les voies de court-circuit d'émetteur commandées de chaque thyristor possèdent une borne de commande (G1, G2), qui leur est associée, ou dans lequel les voies de court-circuit d'émetteur commandées des deux thyristors possèdent une borne commune de commande (G).

5. Triac suivant la revendication 4, dans lequel la couche de base (1a) de type p d'un premier thyristor est munie d'une électrode d'amorçage (19), qui possède une borne (Z) pour un circuit d'amorçage et est en contact avec une région de commande (20) insérée dans cette couche de base (1a) et possédant un dopage de type opposé, et dans lequel la borne (Z) du circuit d'amorçage est reliée par l'intermédiaire d'un circuit additionnel (33) à la borne commune de commande (G) ou est reliée par l'intermédiaire d'autres circuits additionnels (34, 25), aux bornes de commande (G1, G2) associées aux voies de court-circuit d'émetteur commandées des différents thyristors.

6. Triac suivant la revendication 5, dans lequel le circuit additionnel (33) est constitué par un amplificateur inverseur et, dans le cas de l'utilisation de structures MIS du type à enrichissement, les autres circuits additionnels (34, 35) sont réalisés sous la forme de circuits d'inversion de polarité présentant une fonction de décalage de niveau.

7. Procédé pour faire fonctionner un triac suivant la revendication 4 ou 5, dans lequel des impulsions de tension (P1) possédant une première polarité sont envoyées à la borne de commande (G1) des voies de court-circuit d'émetteur des premiers thyristors et des impulsions de tension possédant une seconde polarité (P2) sont envoyées à la borne de commande (G2) des voies de court-circuit d'émetteur du second thyristor.

8. Procédé pour faire fonctionner un triac suivant la revendication 4 ou 5, dans lequel les impulsions de tension (P1, P2) possédant les deux polarités sont envoyées à la borne commune de commande (G).

FIG 1

# FIG 2

# FIG 3

# FIG 5

# FIG 4